# EUROPÄISCHE PATENTANMELDUNG

(11) **EP 4 310 905 A1**
(43) Veröffentlichungstag der Anmeldung: **24.01.2024**
(21) Anmeldenummer: 22185396.3
(22) Anmeldetag: 18.07.2022
(51) Int. Cl.: H01L 23/488, H01L 21/603

(54) **SINTERPREFORM MIT EINEM MASSIVEN KERN UND SINTERSCHICHTEN AUF BEIDEN SEITEN DES KERNS, VERFAHREN ZUR HERSTELLUNG EINER DRUCKSINTERVERBINDUNG VON ZWEI FÜGEPARTNERN DAMIT UND ENTSPRECHENDE ANORDNUNG UMFASSEND EINE DRUCKSINTERVERBINDUNG VON ZWEI FÜGEPARTNERN**

(71) Anmelder: Siemens Aktiengesellschaft, 80333 München (DE)
(72) Erfinder: Nachtigall-Schellenberg, Christian, 14480 Potsdam (DE); Strogies, Jörg, 14163 Berlin (DE)
(74) Vertreter: Siemens Patent Attorneys

(57) **Zusammenfassung**

Eine Sinterpreform (10) weist einem massiven Sinterkern (13) auf, wobei der Kern (13) wenigstens ein erstes Material (14) und beidseitig eine unverdichtete Sinterschicht (11a, 11b) aufweist, wobei das erste Material (14) einen Längenausdehnungskoeffizienten unter 20∙10⁻⁶ K⁻¹ aufweist. Der Kern (13) kann auch wenigstens ein zweites Material (15) aufweisen, welches einen Längenausdehnungskoeffizienten unter 20∙10⁻⁶ K⁻¹ aufweist. Das erste Material (14) kann aus der Gruppe der Metalle oder Übergangsmetalle, insbesondere aus den Gruppen 8 bis 13 des Periodensystems gewählt sein und/oder das zweite Material (15) kann aus der Gruppe der Metalle oder Übergangsmetalle, insbesondere aus den Gruppen 3 bis 8 des Periodensystems gewählt sein. Insbesondere können das erste Material (14) Kupfer und/oder das zweite Material (15) Molybdän umfassen. Der Kern (13) kann mehrere abwechselnde Schichten des ersten Materials (14) und des zweiten Materials (15) umfassen. Alternativ kann im Kern (13) das zweite Material (15) dispergiert im ersten Material (14) vorliegen, insbesondere als Matrix. Der Kern (13) kann das zweite Material (15) in veränderlichem Anteil zum ersten Material (14) umfassen, insbesondere so dass das zweite Material (15) graduell abnimmt, von der Grenze zur einen unverdichteten Sinterschicht (11a) hin zur Grenze zur anderen unverdichteten Sinterschicht (11b) hin. Die unverdichteten Sinterschichten (11a, 11b) können aus Silber sein, beziehungsweise Silber enthalten, können aber auch aus der Materialgruppe mit Längenausdehnungskoeffizienten unter 20∙10⁻⁶ K⁻¹ gewählt sein. Die unverdichteten Sinterschichten (11a, 11b) können unterschiedliche Materialien umfassen. In einem Verfahren zur Herstellung einer Drucksinterverbindung von zwei Fügepartnern (16, 17) wie einem Substrat (16) (insbesondere einem DCB-Substrat) und einem Leistungshalbleiter (17) wird eine solche Sinterpreform (10) zwischen den zwei Fügepartnern (16, 17) und diese zwischen zwei Sinterwerkzeugen (19) angeordnet, so dass diese Sinterpreform (10) in einem Druck- und Temperaturschritt (p, T) eine Fügeschicht (101) zwischen den Fügepartnern (16, 17) ausbildet, mittels der die Fügepartner (16, 17) materialschlüssig miteinander verbunden sind. In einem vorbereitenden Schritt kann die Sinterpreform (10) hergestellt werden, welcher Schritt ein Bilden des Kerns (13) aus wenigstens einem ersten Material (14) und einem zweiten Material (15) umfasst, sowie ein Applizieren der unverdichteten Sinterschichten (11a, 11b) direkt auf den Sinterkern (13), insbesondere mittels Aufbringens als Partikelpaste. Eine Anordnung, insbesondere ein elektronisches Bauelement oder eine elektronische Baugruppe, umfasst eine Drucksinterverbindung von zwei Fügepartnern (16, 17), aufweisend eine Fügeschicht (101) zwischen den Fügepartnern (16, 17), mittels der die Fügepartner (16, 17) materialschlüssig miteinander verbunden sind, wobei die Fügeschicht (101) das erste Material (14) und das zweite Material (15) aufweist, welche vor dem Sinterschritt den Sinterkern (13) der Sinterpreform (10) bildeten oder von diesem umfasst waren, und wenigstens das dritte Material aufweist, welches vor dem Sinterschritt die wenigstens eine Sinterschicht (11a, 11b) bildete oder von diesen umfasst war und wobei das erste Material (14), das zweite Material (15) und das dritte Material einen Längenausdehnungskoeffizienten aufweisen, welcher an den oder die Längenausdehnungskoeffizienten der beiden Fügepartner (16, 17) angepasst ist, so dass die Differenz der Längenausdehnungskoeffizienten weniger als 16∙10⁻⁶ K⁻¹, insbesondere weniger als 12∙10⁻⁶ K⁻¹, bevorzugt weniger als 10∙10⁻⁶ K⁻¹ beträgt. Die Anordnung kann auch ein viertes Material aufweisen, welches zusammen mit dem dritten Material vor dem Sinterschritt unterschiedliche Sinterschichten (11a, 11b) bildete, wobei die unterschiedlichen Materialien Längenausdehnungskoeffizienten aufweisen, welche an die Längenausdehnungskoeffizienten der beiden Fügepartner (16, 17) angepasst sind, so dass die Differenzen der Längenausdehnungskoeffizienten zwischen den Fügepartnern (16, 17) und angrenzender Sinterschicht (11a, 11b) beziehungsweise Sinterpreformoberfläche weniger als 16∙10⁻⁶ K⁻¹, insbesondere weniger als 12∙10⁻⁶ K⁻¹ , bevorzugt weniger als 10∙10⁻⁶ K⁻¹ betragen. Diese Ausführung der Sinterpreform (10) hat den Vorteil, Fehlanpassungen im Sinterprozess zu vermindern und gleichzeitig eine Beibehaltung der bevorzugten Fügezoneneigenschaften, insbesondere der Fügezonengröße beibehalten zu können. Dies ermöglicht daher im Gegensatz zu bisherigen Lösungsansätzen eine Beibehaltung oder sogar Vergrößerung des Prozessraums und auch eine Verbesserung der Funktionalitäten der Anbindungen innerhalb einer Baugruppe oder eines Bauteils. Die Sinterpreform (10) hat den weiteren Vorteil, eine ideale thermomechanische Anpassung an die Fügepartner (16, 17) zu gewährleisten und stellt demnach ein Eigenspannung minimierendes Sinterhalbzeug dar. Bei der Materialauswahl und Kerngestaltung der Sinterpreform (10) wird auf eine möglichst minimale Differenz der Längenausdehnungskoeffizienten von Fügepartner (16, 17) und Sinterpreform (10) geachtet.

## Beschreibung

Die vorliegende Erfindung betrifft eine Sinterpreform, eine Anordnung mit Sinterverbindung und ein Verfahren zur Herstellung einer Sinterverbindung.

In der Verarbeitung, Herstellung und Montage von Halbleitern und Halbleiterkomponenten, z. B. im Bereich der Halbleiterbauteile für elektronische Bauelemente und elektronische Baugruppen, werden zum Montieren und/oder Verbinden verschiedenen Verfahren eingesetzt. Ein vorteilhaftes Verfahren hinsichtlich elektrischer, thermischer und mechanischer Anbindung von Bauelementen auf Baugruppen ist das Drucksinterverfahren. Dieses hat besondere Vorteile im Anwendungsbereich der Herstellung von leistungselektronischen Modulen.

Bei einem derartigen Drucksinterverfahren werden zwei Fügepartner in einem Drucksinterprozess miteinander verbunden. Dazu wird eine Sinterpaste oder Sintermaterial in Chip- oder Pelletform zwischen zwei Fügepartnern aufgetragen oder eine Sinterpreform zwischen zwei Fügepartnern platziert. Danach folgt der Druck- und Temperaturschritt, in dem die beiden Fügepartner miteinander verpresst werden und mittels gleichzeitigen Erwärmens und Annäherung der noch schwach miteinander in Kontakt befindlichen Sinterpartikel vorwiegend durch Festkörperdiffusion zusammenwachsen, so dass eine Kompaktierung der Sinterschicht erfolgt. Zielstellung ist hierbei zumeist einen möglichst porenarmen Festkörper zu generieren.

Bei bisherigen Drucksinterverfahren im Bereich der Halbleiterbauelemente entstehen durch das Drucksinterverfahren thermomechanische Fehlanpassungen der Sinterschicht relativ zur angrenzenden Fügepartneroberfläche. Derartige thermomechanische Fehlanpassungen passieren in Abhängigkeit der Fügetemperatur im Drucksinterprozess. Besonders im Bereich der sensitiven Halbleiterstrukturen können thermomechanische Fehlanpassungen von großem Nachteil sein. Je nach Verformungsbehinderung können sich derartige Fehlanpassungen zwischen Sinterschicht und Fügepartnern in Eigenspannungen oder Wölbungen, also sehr starken Verformungen, auswirken. Derartige Effekte können dann wiederum Brüche oder latente Zuverlässigkeitsprobleme bewirken und nach sich ziehen. Typischerweise erhöht eine große Differenz zwischen den Ausdehnungskoeffizienten der Materialien der beteiligten Werkstoffe eine erhöhte Fehlanpassungsgefahr. Die linearen Ausdehnungskoeffizienten von Silizium und Silber beispielsweise unterscheiden sich um ca. 17 x 10⁻⁶ K⁻¹, beides typische Materialien im beschriebenen Anwendungsbereich, Silizium als Halbleitermaterial einer der Fügepartner und Silber ein bisher bevorzugt eingesetztes Sintermaterial zur Anbindung von Siliziumhalbleitern auf Baugruppen.

Versuche gehen dahin, Fehlanpassungen beim Drucksinterprozess zu vermindern, indem die Fügetemperaturen möglichst niedrig gehalten werden. Auch wird versucht durch Designanpassungen im Bereich der Fügezonen eine Fehlanpassung zu vermeiden. Beispielsweise werden erhöhte Fügezonen geplant, was die Fügezonenqualität selbst jedoch wiederum vermindern kann. Eine Erhöhung der Fügezone verstärkt insbesondere problematische Einflüsse auf die konstruktiven Eigenschaften der Fügepartner bzw. des zu erzeugenden Bauteils oder der zu bestückenden Baugruppe.

Ausgehend vom zuvor beschriebenen Stand der Technik liegt der Erfindung die Aufgabe zugrunde, derartige Fehlanpassungen in einem Sinterprozess bzw. in einem Bauteil mit Sinterverbindung zu vermindern.

Diese Aufgabe wird durch die Merkmale des unabhängigen Patentanspruchs 1 gelöst. Die auf eine Anordnung mit Sinterverbindung bezogene Aufgabe wird gelöst durch die Merkmale des Anspruchs 11 und die auf ein Sinterverfahren bezogene Aufgabe wird gelöst durch Merkmale des Anspruchs 13.

In den Unteransprüchen sind weitere vorteilhafte Maßnahmen aufgelistet, die beliebig miteinander kombiniert werden können, um weitere Vorteile zu erzielen.

Die erfindungsgemäße Sinterpreform zur Drucksinterverbindung von zwei Fügepartnern weist einen massiven Sinterkern auf, wobei der Kern wenigstens ein erstes Material sowie beidseitig je eine unverdichtete Sinterschicht aufweist, und wobei das erste Material einen Längenausdehnungskoeffizienten unter 20·10⁻⁶ K⁻¹ aufweist.

Diese erfindungsgemäße Ausführung einer Sinterpreform hat den Vorteil Fehlanpassungen im Sinterprozess zu vermindern und gleichzeitig eine Beibehaltung der bevorzugten Fügezoneneigenschaften, insbesondere der Fügezonengröße beibehalten zu können. Dies ermöglicht daher im Gegensatz zu bisherigen Lösungsansätzen eine Beibehaltung oder sogar Vergrößerung des Prozessraums und auch eine Verbesserung der Funktionalitäten der Anbindungen innerhalb einer Baugruppe oder eines Bauteils.

Ein wesentlicher Vorteil ist, dass bei der erfindungsgemäßen Sinterpreform auf Silber als Kernmaterial verzichtet wird, da dieses einen sehr hohen Längenausdehnungskoeffizienten aufweist. Des Weiteren ist die Sinterpreform dadurch, insbesondere durch die Materialwahl für den Kern, an die zu verbindenden Fügepartner in ihrer Formausgestaltung anpassbar. Die unverdichteten Sinterschichten dürfen aus Silber sein, beziehungsweise Silber enthalten, können aber auch aus der Materialgruppe mit Längenausdehnungskoeffizienten unter 20 x 10⁻⁶ K⁻¹ gewählt sein. Die erfindungsgemäße Preform hat den weiteren Vorteil eine ideale thermomechanische Anpassung an die Fügepartner zu gewährleisten und stellt demnach ein Eigenspannung minimierendes Sinterhalbzeug dar.

Die angegebene Sinterpreform kann vorteilhaft auf ihre jeweilige Funktion eingestellt sein, ob sie elektrisch leitfähig sein soll, thermisch leitfähig aber elektrisch isolierend oder ob sie auf eine mechanische Befestigungsfunktion abgestellt ist.

Der Sinterkern kann bei der Zielstellung einer elektrisch und thermisch möglichst leitfähigen Sinterverbindung aus thermomechanisch jeweils vorteilhaften Materialien bestehen. Eine Reduzierung des Missmatches zu Silzium oder auch Siliziumkarbid (SiC) kann hier durch monometallische Kerne aus beispielsweise Molybdän oder Wolfram oder im geringeren Umfang auch Kupfer erzielt werden.

Bei der Zielstellung von thermischer Leitfähigkeit können geeignete Isolatormaterialien zum Einsatz kommen. Als Beispiele sind hier Keramiken zu nennen, etwa Siliziumnitrid (Si₃N₄)-Keramik (CTE ca. 3 x 10⁻⁶ K⁻¹), Aluminiumnitridkeramik (CTE ca. 2 ... 4 x 10⁻⁶ K⁻¹) oder auch Aluminiumoxidkeramiken (CTE ca. 8 x 10⁻⁶ K⁻¹)_{.}

Wenn die mechanische Befestigungsfunktion der Verbindung im Fokus steht, können auch weitere, die Bedingungen der Drucksinterprozessierung überstehende, Materialien Verwendung finden.

Bei den nichtmetallischen, insbesondere keramischen Kernen muss gegebenenfalls eine dünne funktionale Schicht zur metallischen Anbindung der eigentlichen Sinterschicht zur Anwendung kommen. Häufig können aber hierfür bereits an den Fügeoberflächen dünn metallisierte Halbzeuge kommerziell bezogen werden.

In einer sehr vorteilhaften Ausführungsform der Erfindung weist der Kern wenigstens ein erstes Material und ein zweites Material auf, wobei das erste Material und das zweite Material einen Längenausdehnungskoeffizienten unter 20 x 10⁻⁶ K⁻¹ aufweisen.

In einer vorteilhaften Ausführungsform der Erfindung ist die Sinterpreform flächig ausgeführt, insbesondere als Plättchen. Darunter ist zu verstehen, dass die Sinterpreform insbesondere eine flache Quaderform aufweist, die in ihrer flächigen Ausdehnung sehr viel größer ist als in ihrer Höhe. Beispielsweise ist unter einer flächigen Sinterpreform oder einem Sinterpreformplättchen ein dreidimensionaler Körper zu verstehen, dessen Grundfläche mindestens das 5-Fache, beispielsweise das 10-Fache, oder auch das 100-Fache der Körperhöhe beträgt. Auch Sinter-Chips oder -Pellets können dem erfindungsgemäßen Aufbau aus Kernmaterial plus Beschichtung mit unverdichtetem Sintermaterial folgen.

In einer vorteilhaften Ausführungsform der Erfindung weist die Sinterpreform Kernmaterialien auf, deren Schmelzpunkte über 1000°C liegen, wobei das zweite Kernmaterial insbesondere einen Schmelzpunkt über 2000°C, bevorzugt über 2500°C aufweist. Unter Schmelzpunkt ist die Temperatur bei Umgebungsdruck zu verstehen, bei der das Material schmilzt, d. h. vom festen in den flüssigen Aggregatszustand übergeht. Die Schmelzpunkte hier sind bei Normaldruck angegeben. Insbesondere liegt die Schmelztemperatur eines der Kernmaterialien oberhalb der Fügetemperatur.

Insbesondere werden für die erfindungsgemäße Sinterpreform als erstes Material ein Metall oder ein Übergangsmetall verwendet, bevorzugt aus den Gruppen 8 bis 13 des Periodensystems. Das zweite Material des Kerns ist bevorzugt ein Metall oder ein Übergangsmetall, insbesondere aus den Gruppen 3 bis 8 des Periodensystems.

Besonders bevorzugte Beispiele für ein erstes Material sind Kupfer und für ein zweites Material sind Molybdän. Kupfer hat einen geringeren Längenausdehnungskoeffizienten als Silber, Molybdän hat einen deutlich niedrigeren Längenausdehnungskoeffizienten als Silber, vergleiche Tabelle:

| Material | Längenausdehnungskoeffizient [10-⁶ K⁻¹] |
|---|---|
| Molybdän | 5, 2 |
| Kupfer | 17 |
| Silber | 19, 5 |

In einer besonders bevorzugten Ausführungsform der Erfindung weist die Sinterpreform einen Kern auf, welcher mehrere abwechselnde Schichten des ersten Materials und des zweiten Materials umfasst. Insbesondere liegen mehr als zwei, mehr als vier, mehr als sechs, mehr als acht oder mehr als zehn wechselnde Schichten von erstem und zweitem Material im Kern vor.

In einer alternativen sehr bevorzugten Ausführungsform der Erfindung weist die Sinterpreform einen Kern auf, dessen zweites Material dispergiert im ersten Material vorliegt. Dies kann insbesondere in einer Matrixstruktur vorliegen.

Diese Ausführungsformen haben besondere Vorteile gegenüber der Verwendung einer monometallischen Struktur als Kern. Diese heterogenen Strukturen, welche mindestens zwei verschiedene Materialien umfassen, können als Sandwiches oder als Komposit-Strukturen z. B. mit dispergierten Partikeln des zweiten Materials im ersten Material realisiert sein. Derartige Ausgestaltungen des Kerns einer Sinterpreform haben eine besonders gute Anpassungsfähigkeit des massiven Kerns hinsichtlich dessen thermomechanischer Eigenschaften. Gleichzeitig können derartige Sinterpreformkerne analog zur Herstellung von Sinterpreformen mit monometallischen Halbzeugen weiterverarbeitet werden, insbesondere kann der massive Kompositkern einseitig oder beidseitig mit einer Sinterschicht versehen werden. Diese wird bevorzugt als getrocknete, aber unverdichtete Sinterpaste aufgetragen.

Derartige Kompositkerne sind an ihre Anwendung, insbesondere an die Fügepartner anpassbar: In einer vorteilhaften Ausgestaltung der Erfindung umfasst die Sinterpreform einen Kern, dessen zweites Material dem veränderlichen Anteil zum ersten Material vorliegt, insbesondere kann das zweite Material graduell abnehmen, von der Grenze zu einer unverdichteten Sinterschicht hin zur Grenze zur anderen unverdichteten Sinterschicht hin.

Eine derartige Ausführungsform erlaubt eine ideale Anpassung der Sinterpreform an zwei unterschiedliche Fügepartner. Mit dem veränderlichen Anteil des zweiten Materials dispergiert im ersten Material verändert sich auch der Längenausdehnungskoeffizient des Sinterpreformkerns.

Insbesondere können auch die Sinterschichten, die insbesondere beidseitig auf den großen Außenflächen des Kerns aufgebracht sind, aus unterschiedlichen Materialien gestaltet sein bzw. unterschiedliche Materialien umfassen.

Die erfindungsgemäße Anordnung mit einer Drucksinterverbindung umfasst zwei Fügepartner, eine Fügeschicht zwischen den Fügepartnern, mittels der die Fügepartner materialschlüssig miteinander verbunden sind, wobei die Fügeschicht ein erstes Material und ein zweites Material aufweist, welches insbesondere vor dem Sinterschritt den Sinterkern der Sinterpreform bildete oder von diesem umfasst war, und wenigstens ein drittes Material aufweist, welches vor dem Sinterschritt insbesondere die wenigstens eine Sinterschicht bildete oder von dieser umfasst war und wobei erstes Material, zweites Material und drittes Material einen Längenausdehnungskoeffizienten aufweisen, welche an den oder die Längenausdehnungskoeffizienten der beiden Fügepartner angepasst ist, so dass die Differenz der Längenausdehnungskoeffizienten weniger als 16 x 10⁻⁶ K⁻¹, insbesondere weniger als 12 × 10⁻⁶ K⁻¹, bevorzugt weniger als 10 x 10⁻⁶ K ⁻¹ beträgt. Bei der Materialauswahl und Kerngestaltung der Sinterpreform wird auf eine möglichst minimale Differenz der Längenausdehnungskoeffizienten von Fügepartner und Sinterpreform geachtet. Zum Vergleich, bisherige Sinterpreforms aus monometallischem Silber bewirken eine Längenausdehnungskoeffizientendifferenz zu einem Silizium-Fügepartner von nahezu 17 x 10⁻⁶ K⁻¹.

In einer beispielhaften Ausgestaltung der Erfindung umfasst die Anordnung ein drittes und ein viertes Material, welche Materialien vor dem Sinterschritt unterschiedliche Sinterschichten bildeten oder von den unterschiedlichen Sinterschichten umfasst waren, wobei die unterschiedlichen Materialien Längenausdehnungskoeffizienten aufweisen, welche an die Längenausdehnungskoeffizienten der beiden Fügepartner angepasst sind, sodass die Differenzen der Längenausdehnungskoeffizienten zwischen Fügepartnern und angrenzender Sinterschicht beziehungsweise angrenzender Sinterpreformoberfläche weniger als 16 x 10⁻⁶ K⁻¹ betragen.

Bei der Anordnung mit einer Drucksinterverbindung handelt es sich insbesondere um eine elektronische Baugruppe oder ein elektronisches Bauelement. Besonders bevorzugt wird dieses erfindungsgemäße Drucksintern mit Sinterpreform bei sensiblen Halbleiterbauelementen eingesetzt.

Das erfindungsgemäße Verfahren zur Herstellung einer Drucksinterverbindung von zwei Fügepartnern, bei dem eine Sinterpreform nach einem der vorhergehenden Ausführungsformen der Erfindung eingesetzt wird, werden zwei Fügepartner zwischen zwei Sinterwerkzeugen angeordnet, sodass diese in einem Druck- und Temperaturschritt erwärmt und miteinander verpresst werden. Die Sinterpreform wird im Druck- und Temperaturschritt zu einer Fügeschicht zwischen den Fügepartnern ausgebildet. Die Fügepartner sind darüber dann materialschlüssig miteinander verbunden.

Bei diesem erfindungsgemäßen Verfahren, mit dem Einsatz einer erfindungsgemäßen Sinterpreform, ist von besonderem Vorteil die Temperatur im Druck- und Temperaturschritt niedrig zu halten, was sich wiederum positiv auf alle beteiligten Materialien der Bauelemente auswirkt, da eine Verminderung thermischer Beschädigungen erwirkt wird.

Bevorzugt umfasst das Verfahren einen vorbereitenden Schritt, in dem eine Sinterpreform hergestellt wird, umfassend das Bilden des Kerns aus wenigstens einem ersten Material und einem zweiten Material, sowie ein Applizieren der wenigstens einen unverdichteten Sinterschicht direkt auf dem Sinterkern, insbesondere mittels Aufbringens als Partikelpaste. Bei der Herstellung des Kerns kann die Kernzusammensetzung aus den wenigstens zwei Materialien auch graduell verändert werden.

In einer vorteilhaften Ausgestaltung der Erfindung wird in dem Sinterverfahren im Druck- und Temperaturschritt eine Temperatur beispielsweise zwischen 100°C und 1000°C angewendet, insbesondere zwischen 150°C und 700°C, bevorzugt zwischen 200°C und 500°C, besonders bevorzugt unter 300°C. Eine bevorzugte Zeitdauer des Druck- und Temperaturschritts im Verfahren kann zwischen einer und fünf Minuten betragen. Der Einsatz der erfindungsgemäßen Sinterpreform bewirkt, dass geringere Temperaturen und geringere Sinterdauern ermöglicht sind.

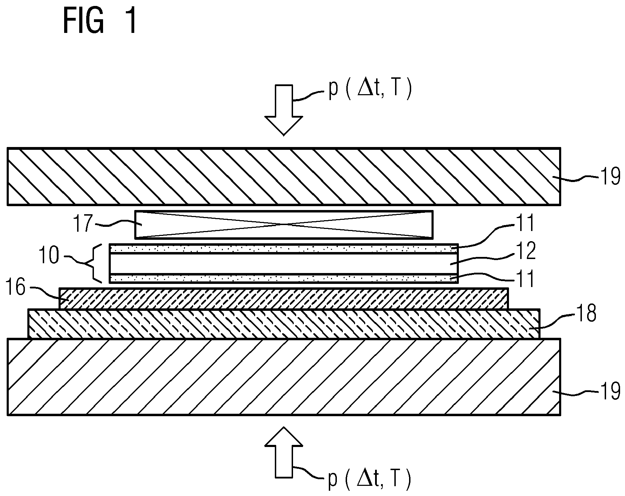

Beispiele und Ausführungsformen der vorliegenden Erfindung werden noch in exemplarischer Weise mit Bezug auf die Figuren 1 bis 4 der angehängten Zeichnung beschrieben:
Figur 1 zeigt die Ausgangssituation in einer Schnittansicht, wie bisher ein Drucksinteraufbau mit monometallischer Fügeschicht 12 realisiert wurde. Dabei ist zwischen zwei beheizten Druckstempeln einer Sinterpresse 19 eine Basis 18, beispielsweise aus einer Keramik wie Aluminiumoxid Al₂O₃, oder Aluminiumnitrid AlN oder auch einer Basis aus metallischem Aluminium oder Kupfer gezeigt, auf der ein sogenanntes Topmetall, eine Metallschicht 18 aufgebracht ist, welche das Substrat oder den ersten Fügepartner 16 darstellt. Als Substrat oder erster Fügepartner 16 kann beispielsweise eine DCB-Keramik eingesetzt werden, welche eine Struktur der Aufbau- und Verbindungstechnik ist, die eine besonders enge elektrisch-thermische Verbindung elektronischer Bauteile und Chips mittels Kupfer ermöglicht. Besonders in der Leistungselektronik ist die elektrisch-thermische Anbindung von besonderer Bedeutung für einen effektiven Wärmeabtransport. In der DCB Aufbau- und Verbindungstechnik wird Kupfer besonders bevorzugt als Leiterschicht, Leiterbahnstrukturen oder als Kontaktflächen eingesetzt. Auf dieses Substrat 16, welches den ersten Fügepartner darstellt, wird dann eine Sinterpreform 10 aufgelegt, die in der Figur 1 noch aus einem monometallischen Kern 12 und zweiseitig angebrachten Sintermetallschichten 11 besteht. Auf diese wiederum wird der zweite Fügepartner 17 aufgebracht, beispielsweise ein Leistungshableiter wie Silizium Si, Siliziumcarbid SiC oder Galliumnitrid GaN. Die Fügepartner 16, 17 sind im Sinterzeitpunkt entsprechend ihrer Zwangslage zwischen den Sinterwerkzeugen 19 in ihrer Ausrichtung bzw. Ausdehnung beschränkt: Bei Abkühlung kommt es dann zur Auswirkung der hohen CTE-Differenz in Verformungen und Fehlanpassungen zwischen der Sinterpreform 10 und den Fügepartnern 16, 17.

Des Weiteren ist durch zwei Pfeile angedeutet, dass im Sinterschritt die Sinterwerkzeuge 19 zusammengepresst werden, mit einem vorgebbaren Druck p, für eine vorgebbare Zeitdauer Δt und bei einer einstellbaren Temperatur T.

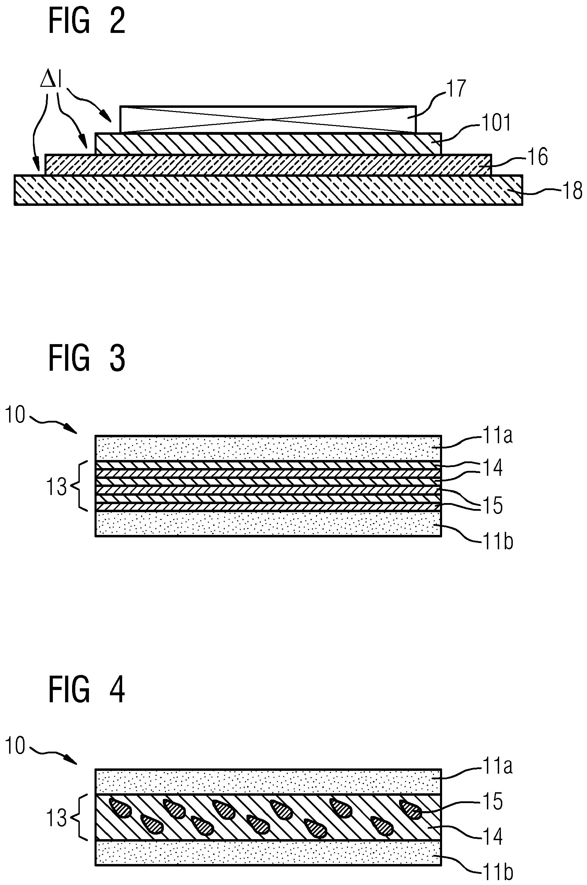

In der Figur 2 ist beispielhaft eine fertig verpresste Drucksinterverbindung im Querschnitt gezeigt, mit Basis 18, Substrat 16, fertiger Füge- oder Sinterschicht 101 und zweitem Fügepartner 17, welcher insbesondere ein Leistungshalbleiter ist. Δl zeigt die Längenverformungen an, welche als Folge des Drucksinterprozesses erscheinen. Nicht dargestellt aber ebenso durch den Drucksinterprozess entstehen an den Kontaktflächen der Materialien Eigenspannungen im Material, welche sich nachteilig als Defekte bis hin zu Rissen im Bauteil in der Anordnung bzw. der Baugruppe auswirken können.

Mit den erfindungsgemäßen Sinterformteilen 10, welche speziell auf die Fügepartner 16, 17 anpassbar sind, können verformungsreduzierte Sinteranbindungen geschaffen werden. In den Figuren 3 und 4 sind zwei verschiedene Varianten des erfindungsgemäßen optimierten Sinterpreformkerns 13 gezeigt, welcher in beiden Fällen mindestens zwei Materialien 14, 15 enthält, welche Materialien 14, 15 wie in Figur 3 gezeigt, in einer Schichtabfolge von beispielsweise sechs Schichten den Kern 13 bilden können. Eine Schicht ist dabei bevorzugt nur wenige 10 µm dick. Ein sogenannter Sandwichcore 13, z. B. mit einer Abfolge von Kupfer- und Molybdänschichten, hat den besonderen Vorteil einfacher Herstellbarkeit. Der Kern 13 trägt eine erste und eine zweite unverdichtete Sinterschicht 11a und 11b, welche aus demselben Material oder aus unterschiedlichen Materialien sein können. Eine derartige Sinterpreform 10 kann bei Fügetemperaturen unter 300°C bevorzugt um die 250°C verarbeitet werden, ist aber auch gegenüber anderen Fügetemperaturen unempfindlich.

Ein monometallischer Sinterkern 12 ist stets auf einen sehr engen Temperaturbereich für die Verarbeitung begrenzt. Die hohe Differenz des Ausdehnungskoeffizienten zum Fügepartner 16, 17 ist durch den optimierten Sandwichkern 13 reduziert. Durch die erfindungsgemäße Sinterpreform 10 ist gleichzeitig eine sehr gute Prozessintegration in die bisherigen Prozesse der Aufbau- und Verbindungstechnik möglich.

Die in Figur 4 gezeigte zweite Variante eines Sinterpreformkerns 13 zeigt ein zweites Material 15, welches dispergiert im ersten Material 14 vorliegt, z. B. in Form eines Matrixcores. Dieser kann hinsichtlich des Anteils des zweiten Materials 15 optimiert werden, insbesondere auf die Materialeigenschaften der Fügepartner 16, 17. Der Einsatz eines derartig optimierten Matrixcores 13 ist besonders in der DCB-Verbindungstechnik von Vorteil. Bei dem optimierten Matrixcore 13 ergeben sich gute Tuningmöglichkeiten der Kerngestaltung z. B. mit unterschiedlichem Anteil des zweiten Materials 15 im Verlauf der Dicke des Kerns. Beispielsweise kann der Anteil des zweiten Materials 15 von der Grenze zur oberen Sinterschicht 11a hin zur unteren Sinterschicht 11b abnehmen, stufenweise oder graduell.

Beim Einsatz von Kupfer als erstem und Molybdän als zweitem Material könnte man den Kern 13 derart tunen, dass der Kupferanteil nahe einer Kupferkeramikanbindung 16 sehr hoch ist, um dort einen möglichst geringen Unterschied der Längenausdehnungskoeffizienten vorliegen zu haben. Der Molybdänanteil würde in Richtung des zweiten Fügepartners 17, welches insbesondere ein Siliziumhalbleiter sein kann, erhöht werden.

Zusammenfassend wird festgehalten, dass die erfindungsgemäße Sinterpreform 10 ideal in bestehende Drucksinterverfahrensabläufe integrierbar ist. Gleichzeitig von besonderen Optimierungs- und Anpassungsmöglichkeiten hinsichtlich der thermischen und elektrischen Eigenschaften der Fügepartner 16, 17 anpassbar ist. Besonders vorteilhaft ist sie in der Leistungshalbleiterelektronik einsetzbar. Obwohl die Erfindung im Detail durch das bevorzugte Ausführungsbeispiel Kupfer und Molybdän näher illustriert und beschrieben wurde, ist die Erfindung nicht durch die offenbarten Materialbeispiele eingeschränkt.

### Bezugszeichen:

- 10: Fügeschicht: Sinterpreform, z.B. monometallisch, aus massivem Kern und beidseitiger Auflage mit unverdichtetem Sintermaterial, z.B. Silber-Preform
- 101: Sinterschicht, nach erfolgter Sinteranbindung
- 11a,b: unverdichtetes Sintermaterial
- 12: Kern, z.B. herkömmlich massiver Metallkern, inbesondere aus Silber
- 13: optimierter Kern, z.B. Sandwich-Core oder Matrix-Core
- 14: erstes Sintermaterial, insbesondere aus Metall, z.B. Kupfer
- 15: zweite Sintermaterial, insbesondere aus Metall, z.B. Molybdän
- 16: Top-Metal (Substrat), z.B. DCB-Keramik
- 17: Leistungshalbleiter (Si, SiC, GaN)
- 18: Basis (Keramik Al2O3, AlN oder auch metallisch Al, Cu)
- 19: Beheizter Druckstempel der Sinterpresse (oben und unten)
- p (Δt, T): Druck auf Druckstempel bei Temperatur T und für einen Zeitraum Δt
- Δl: Längendifferenz, Folge: Verformung und/oder Eigenspannungen

## Patentansprüche

1. Sinterpreform (10) zur Drucksinterverbindung von zwei Fügepartnern (16, 17), aufweisend einen massiven Sinterkern (13), wobei der Kern (13) wenigstens ein erstes Material (14) sowie beidseitig je eine unverdichtete Sinterschicht (11a,b) aufweist, wobei das erste Material (14) einen Längenausdehnungskoeffizienten unter 20·10⁻⁶ K⁻¹ aufweist.

2. Sinterpreform (10) nach Anspruch 1, wobei der Kern (13) wenigstens ein zweites Material (15) aufweist, welches einen Längenausdehnungskoeffizienten unter 20·10⁻⁶ K⁻¹ aufweist.

3. Sinterpreform (10) nach einem der vorstehenden Ansprüche, wobei das erste Material (14) einen Schmelzpunkt ≥ 1.000°C aufweist und/oder das zweite Material (15) einen Schmelzpunkt ≥ 2.000 °C aufweist.

4. Sinterpreform (10) nach einem der vorstehenden Ansprüche, wobei das erste Material (14) aus der Gruppe der Metalle oder Übergangsmetalle, insbesondere aus den Gruppen 8 bis 13 des Periodensystems gewählt ist und/oder das zweite Material (15) aus der Gruppe der Metalle oder Übergangsmetalle, insbesondere aus den Gruppen 3 bis 8 des Periodensystems gewählt ist.

5. Sinterpreform (10) nach einem der vorstehenden Ansprüche, wobei das erste Material (14) Kupfer umfasst und/oder das zweite Material (15) Molybdän umfasst.

6. Sinterpreform (10) nach einem der vorstehenden Ansprüche, wobei der Kern (13) mehrere abwechselnde Schichten des ersten Materials (14) und des zweiten Materials (15) umfasst.

7. Sinterpreform (10) nach einem der vorstehenden Ansprüche 1 bis 5, wobei im Kern (13) das zweite Material (15) dispergiert im ersten Material (14) vorliegt, insbesondere als Matrix.

8. Sinterpreform (10) nach einem der vorstehenden Ansprüche, wobei der Kern (13) das zweite Material (15) in veränderlichem Anteil zum ersten Material (14) umfasst, insbesondere das zweite Material (15) graduell abnimmt, von der Grenze zur einen unverdichteten Sinterschicht (11a) hin zur Grenze zur anderen unverdichteten Sinterschicht (11b) hin.

9. Sinterpreform (10) nach einem der vorstehenden Ansprüche, wobei die unverdichteten Sinterschichten (11a,b) unterschiedliche Materialien umfassen.

10. Sinterpreform (10) nach einem der vorstehenden Ansprüche, wobei wenigstens ein Material einer der unverdichteten Sinterschichten (11a, b) einen Längenausdehnungskoeffizienten unter 20·10⁻⁶ K⁻¹ aufweist.

11. Anordnung, insbesondere elektronisches Bauelement oder elektronische Baugruppe, umfassend eine Drucksinterverbindung von zwei Fügepartnern (16, 17), aufweisend eine Fügeschicht (101) zwischen den Fügepartnern (16, 17), mittels der die Fügepartner (16, 17) materialschlüssig miteinander verbunden sind, wobei die Fügeschicht (101) ein erstes Material (14) und ein zweites Material (15) aufweist, welches vor dem Sinterschritt den Sinterkern (13) der Sinterpreform (10) bildete oder von diesem umfasst war, und wenigstens ein drittes Material aufweist, welches vor dem Sinterschritt die wenigstens eine Sinterschicht (11a,b) bildete oder von dieser umfasst war und wobei erstes Material (14), zweites Material (15) und drittes Material (11a, b) einen Längenausdehnungskoeffizienten aufweisen, welcher an den oder die Längenausdehnungskoeffizienten der beiden Fügepartner (16,17) angepasst ist, so dass die Differenz der Längenausdehnungskoeffizienten weniger als 16·10⁻⁶ K⁻¹, insbesondere weniger als 12·10⁻⁶ K⁻¹, bevorzugt weniger als 10·10⁻⁶ K⁻¹ beträgt.

12. Anordnung nach Anspruch 10, umfassend ein drittes und ein viertes Material, welche vor dem Sinterschritt unterschiedliches Sinterschichten (11a,b) bildete, wobei die unterschiedliche Materialien Längenausdehnungskoeffizienten aufweisen, welche an die Längenausdehnungskoeffizienten der beiden Fügepartner (16,17) angepasst ist, so dass die Differenzen der Längenausdehnungskoeffizienten weniger als 16·10⁻⁶ K⁻¹, insbesondere weniger als 12·10⁻⁶ K⁻¹, bevorzugt weniger als 10·10⁻⁶ K⁻¹ beträgt.

13. Verfahren zur Herstellung einer Drucksinterverbindung von zwei Fügepartnern (16, 17), bei dem eine Sinterpreform (10) nach einem der vorgehenden Ansprüche 1 bis 11, zwischen den zwei Fügepartnern (16, 17) und diese zwischen zwei Sinterwerkzeugen (19) angeordnet wird, dass diese Sinterpreform (10) in einem Druck- und Temperaturschritt (p, T) eine Fügeschicht (101) zwischen den Fügepartnern (16, 17) ausbildet, mittels der die Fügepartner materialschlüssig miteinander verbunden sind.

14. Verfahren nach Anspruch 13, bei dem in einem vorbereitenden Schritt eine Sinterpreform (10) nach einem der vorgehenden Ansprüche hergestellt wird, welcher Schritt ein Bilden des Kerns (13) aus wenigstens einem ersten Material (14) und einem zweiten Material (15) umfasst, sowie ein Applizieren der wenigstens einen unverdichteten Sinterschicht (11) direkt auf den Sinterkern (13), insbesondere mittels Aufbringens als Partikelpaste.

15. Verfahren nach Anspruch 13 oder 14, bei dem die Temperatur (T) im Druck- und Temperaturschritt (p, T) unter 300 °C liegt und/oder die Zeitdauer (Δt) des Druck- und Temperaturschritts (p, T) zwischen 1 Minute und 5 Minuten liegt.
